(19) **Europäisches Patentamt European Patent Office Office européen des brevets**

(11)  **EP 1 021 590 B1**

(12)  # EUROPEAN PATENT SPECIFICATION

(45) Date of publication and mention
of the grant of the patent:
**17.11.2010 Bulletin 2010/46**

(51) Int Cl.:
***H01M 4/88*** (2006.01)   ***H01M 4/86*** (2006.01)
***H01M 8/10*** (2006.01)

(21) Application number: **98948150.2**

(22) Date of filing: **11.09.1998**

(86) International application number:
**PCT/US1998/018938**

(87) International publication number:
**WO 1999/013128 (18.03.1999 Gazette 1999/11)**

(54) **A METHOD OF DEPOSITING AN ELECTROCATALYST AND ELECTRODES FORMED BY SUCH METHOD**

EIN VERFAHREN ZUM AUFBRINGEN EINES ELEKTROKATALYSATORS UND DAMIT HERGESTELLTE ELEKTRODEN

PROCEDE DE DEPOT D'UN ELECTROCATALYSEUR ET FABRICATION D'ELECTRODES PAR CE PROCEDE

(84) Designated Contracting States:
**DE FR GB IT**

(30) Priority: **11.09.1997 US 927739**

(43) Date of publication of application:
**26.07.2000 Bulletin 2000/30**

(73) Proprietor: **Gore Enterprise Holdings, Inc.
Newark, DE 19714 (US)**

(72) Inventors:
 • **DEARNALEY, Geoffrey**
 **San Antonio, TX 78256 (US)**
 • **ARPS, James, H.**
 **San Antonio, TX 78240 (US)**

(74) Representative: **Wain, Christopher Paul et al
A.A. Thornton & Co.
235 High Holborn
London
WC1V 7LE (GB)**

(56) References cited:
 **WO-A-97/23919**   **DE-C1- 19 513 292**
 **US-A- 4 460 660**   **US-A- 5 084 144**
 **US-A- 5 277 996**   **US-A- 5 518 831**
 **US-A- 5 624 718**   **US-A- 5 750 013**

 • **TICIANELLI E A ET AL: "LOCALIZATION OF PLATINUM IN LOW CATALYST LOADING ELECTRODES TO ATTAIN HIGH POWER DENSITITES IN SPE FUEL CELLS" JOURNAL OF ELECTROANALYTICAL CHEMISTRY AND INTERFACIAL ELECTROCHEMISTRY, ELSEVIER, AMSTERDAM, NL, vol. 251, no. 2, 23 September 1988 (1988-09-23), pages 275-295, XP000884567 ISSN: 0022-0728**

EP 1 021 590 B1

**Description**

**Field of the Invention**

The application provides a process for depositing a minimal load of an electrocatalyst (preferably comprising platinum) onto a support, preferably a support capable of use as a fuel cell electrode (most preferably carbon cloth), while maximizing the catalytic activity of the catalyst. The application also is directed to products comprising novel electrocatalytic coatings comprising rod-shaped structures.

**Background of the Invention**

A fuel cell is an electrochemical device in which electrical energy is generated by chemical reaction without altering the basic components of the fuel cell--that is, the electrodes and the electrolyte. Fuel cells combine hydrogen and oxygen without combustion to form water and to produce direct current electric power. The process can be described as electrolysis in reverse. The fuel cell is unique in that it converts chemical energy continuously into electrical energy without an intermediate conversion to heat energy.

Fuel cells have been pursued as a source of power for transportation because of their high energy efficiency (unmatched by heat engine cycles), their potential for fuel flexibility, and their extremely low emissions. Fuel cells have potential for stationary and vehicular power applications; however, the commercial viability of fuel cells for power generation in stationary and transportation applications depends upon solving a number of manufacturing, cost, and durability problems.

One of the most important problems is the cost of the proton exchange catalyst for the fuel cell. Some of the most efficient catalysts for low temperature fuel cells are noble metals, such as platinum, which are very expensive. Some have estimated that the total cost of such catalysts is approximately 80% of the total cost of manufacturing a low-temperature fuel cell.

In a typical process, an amount of a desired noble metal catalyst of from about 0.5-4 $mg/cm^2$ is applied to a fuel cell electrode in the form of an ink, or using complex chemical procedures. Unfortunately, such methods require the application of a relatively large load of noble metal catalyst in order to produce a fuel cell electrode with the desired level of electrocatalytic activity, particularly for low temperature applications. The expense of such catalysts makes it imperative to reduce the amount, or loading, of catalyst required for the fuel cell. This requires an efficient method for applying the catalyst.

In recent years, a number of deposition methods, including rolling/spraying, solution casting/hot pressing, and electrochemical catalyzation, have been developed for the production of Pt catalyst layers for proton exchange membrane (PEM) fuel cells. Although thin sputtered Pt coatings deposited on carbon cloth can measurably improve fuel cell performance, this approach generally is not considered to be viable for large area deposition or as a stand alone treatment for applying platinum. Continuing challenges remain in the development of scalable methods for the production of large-area (>300 $cm^2$), high performance (>1$A/cm^2$ at 0.6V) fuel cell electrodes with low Pt loadings (<0.3 $mg/cm^2$).

US-A-5 277 996 describes a fuel cell electrode wherein the electrodes are formed from a layer of a porous substrate material, such as carbon, and a fullerene layer. After deposition of the fullerene layer a layer of platinum is deposited by e-beam evaporation. The substrate can be a fibrous carbon material. The electrode is used in combination with an electrolyte which can be a solid polymer electrolyte.

US-A-5 624 718 teaches a low-temperature method for producing electro-catalytic coatings comprising diamond-like carbon with finely dispersed platinum. The document teaches that the platinum is evaporated by an e-beam and is deposited together with a carbon precursor on a substrate, whcih perferably is a perfluorosulfonic acid membrane.

**Summary of the Invention**

In a first aspect the present invention provides a method defined in claim 1. In a second aspect the present invention provides an electrode defined by claim 7. In a third aspect the present invention provides a membrane electrode assembly defined in claim 11. Further features are defined in the dependent claims.

The present invention provides a method for depositing onto a support a vaporizable composition comprising a catalytic component. The method comprises converting the vaporizable composition into a vapor, and depositing the vapor onto the support in an amount sufficient to produce a concentration of the catalytic component adapted to produce a catalytically effective coating on the support. The invention also is directed to electrodes produced by the method, and to electrodes comprising a support comprising a deposit disposed thereon which comprises a catalytically effective load of an electrocatalyst comprising an electrocatalytic active area at least in part comprising rod-shaped structures.

## Brief Description of the Figures

Figure 1 is a graph depicting the polarization performance of an experimental electrode used as cathode and anode at a cell pressure of 206.85 kPa (30 psig). The experimental electrode was made from a carbon-only ELAT carbon cloth electrode, available from E-TEK, Natick, MA, bearing Pt deposited using electron beam physical vapor deposition (EB-PVD) according to the present invention, as described in Examples III and IV.

Figure 2 is a graph depicting the polarization performance at 206.85 kPa (30 psig) cell pressure of a conventional sputtered Pt catalyzed ELAT gas diffusion media experimental electrode used as cathode and anode, as described in Example IV.

Figure 3 is a graph depicting the polarization performance at 206.85 kPa (30 psig) cell pressure of a conventional sputtered Pt catalyzed ELAT gas diffusion media experimental electrode used as an anode, as described in Example IV.

Figure 4 is a graph depicting a side-by-side comparison of performance at cell and compensated potentials of a conventional sputtered Pt catalyzed experimental electrode and an inventive EB-PVD Pt catalyzed experimental electrode used as a cathode showing the polarization performance at 206.85 kPa (30 psig) cell pressure, as described in Example IV.

Figure 5 is a graph depicting a side-by-side comparison of performance between a conventional sputter deposited Pt electrode and an inventive EB-PVD Pt deposited electrode used as an anode showing the polarization performance at 206.85 kPa (30 psig) cell pressure, as described in Example IV.

Figure 6 is a graph depicting a side-by-side comparison of performance at cell and compensated potentials of another conventional sputter deposited Pt electrode and another inventive EB-PVD Pt deposited electrode used as a cathode showing the polarization performance at 206.85 kPa (30 psig) cell pressure, as described in Example IV.

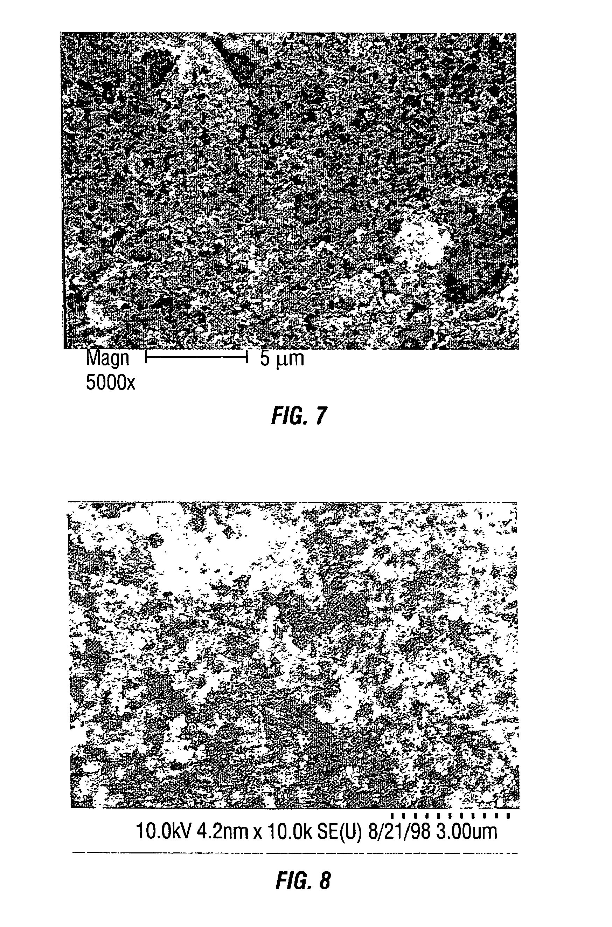

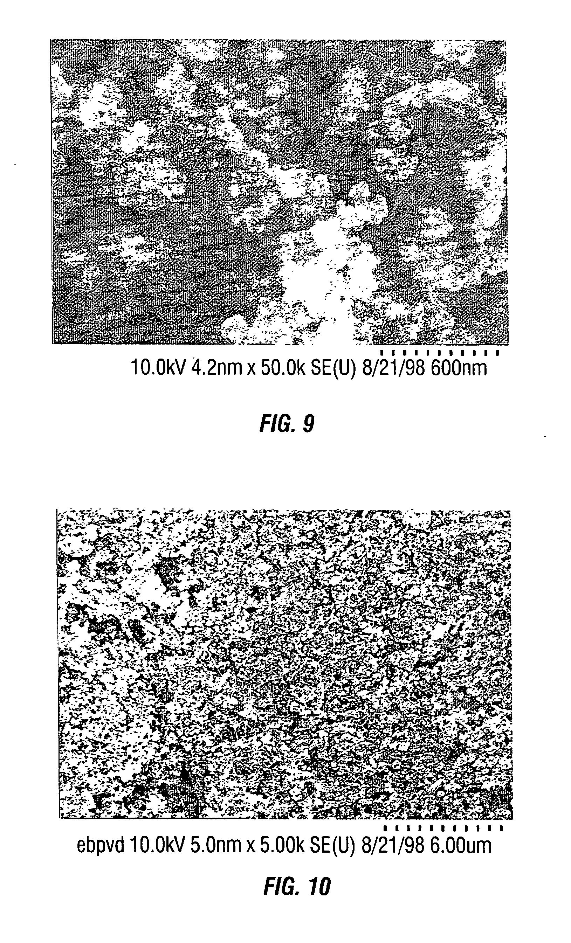

Figures 7-9 are field-emission scanning electron microscopy pictures (micrographs or FE-SEMs) of an uncatalyzed ELAT gas diffusion media at various magnifications.

Figures 10-20 are FE-SEMs of ELAT gas diffusion media catalyzed using EB-PVD of Pt according to the present invention, as described in Examples III. and IV, at various magnifications.

Figures 21-26 are FE-SEMs of ELAT gas diffusion media catalyzed using conventional sputter deposition of Pt, as described in Examples III and IV, at various magnifications.

## Brief Description of the Invention

Vacuum deposition techniques are routinely employed in a variety of applications ranging from metallized layers in the fabrication of semiconductors to barrier coatings for food packaging, hard coatings for cutting tools, and optical thin films. Some of the typical methods employed include chemical vapor deposition, physical vapor or thermal deposition, ion sputtering, and ion beam assisted deposition (IBAD). Because the materials are deposited in a vacuum (typically less than 13.3 mPa, or $1x10^{-4}$ torr), contamination of the films can be minimized while maintaining good control over film thickness and uniformity. Such techniques, in many cases, lend themselves to deposition of materials over large areas via a reel-to-reel or web coating processes.

The present invention uses vacuum deposition techniques, i.e. EB-PVD, to deposit a catalyst onto a support. The support for the claimed coating include, carbon cloth, and carbon paper. Preferred supports are carbon supports.

Useful PEMs include, but are not necessarily limited to polymer electrolyte membranes or monomers, such as NAFION™, available from Dupont, Inc., Wilmington, Delaware, and most preferably a fluoroionomeric membrane comprising a composite of polytetrafluoroethylene with impregnated ion exchange media known as GORE-SELECT®, available from W. L. Gore & Associates, Elkton, Maryland.

Suitable carbon supports include, but are not necessarily limited to, graphite, carbon fiber, and carbon cloth. Suitable commercially available carbon gas diffusion media for use as a support include, but are not necessarily limited to: carbon gas diffusion electrodes; iso-molded graphite; carbon bundles, preferably having 6,000 or 12,000 carbon filaments/bundle; reticulated carbon; carbon cloth; and, carbon paper A preferred carbon support is carbon cloth, preferably a carbon-only ELAT carbon cloth electrode, available from E-TEK, Natick, MA.

The support preferably should resist corrosion in an acid environment, offer good electrical conductivity and, for carbon supports, allow fast permeation of oxygen (cathode) and hydrogen (anode), comply with thin layer manufacturing techniques, and contribute little to the weight and cost of the fuel cell assembly.

A catalyst is deposited onto the support, using vacuum deposition techniques. As used herein, the term "catalyst" is defined as a substance that increases the rate of approach to equilibrium of a chemical reaction without being substantially consumed in the reaction. A catalyst works by forming chemical bonds to one or more reactants and thereby facilitating their conversion. A catalyst does not affect the reaction equilibrium. A catalyst provides for alternate reaction pathways/mechanisms that offer an overall lower activation energy for the reaction, thus accelerating the rate of turnover.

In electrochemical systems the reaction rate (power density/current density) is controlled by controlling temperature and electrocatalysis. Electrocatalysts are substances (metals, metal oxides, non-metals, organometallics, etc.) that can promote the rate of electrochemical reactions, i.e., ionization, deionization, for a given surface area. The electrocatalyst is a substance that accelerates the rate of forward and backward charge transfer reactions for a given redox system (charge transfer reaction) without perturbing chemical equilibrium (thermodynamics is not affected by the presence of a catalyst). An electrocatalyst provides for alternative reaction pathways/mechanisms that offer an overall lower activation energy for the electrochemical reaction, thus accelerating the rate of electrochemical turnover. The rate at which a reaction at an electrode surface proceeds may be limited by the intrinsic kinetics of the heterogeneous process. In non- electrochemical systems, the macroscopically observed reaction rate is the result of a series of elementary processes.

A key difference between an electrocatalyst and other types of catalysts is the ability of the electrocatalyst to manipulate an additional driving force variable: the electric potential. A change in potential of one volt at the surface of the electrocatalyst/electrode can cause a change in reaction rate of eight orders of magnitude. This change may be equivalent to an increase in temperature of several hundred degrees Celsius for a typical catalytic reaction. (i.e., non-electrochemical reaction). For fuel cell applications heterogeneous electrocatalysts exist as foils, deposited films, individual particles or supported particles. The word "heterogeneous" means that the reactant is normally in a different phase (gas or liquid) than the electrocatalyst (solid).

To describe how a particular surface electrocatalyzes/catalyzes a particular reaction requires a knowledge of three factors: the mechanism of the reaction pathway; the chemisorption energy of the surface species; and, the effective activation energy (energies) of the reaction. Metals with empty "d" orbitals are suitable electrocatalysts because they adsorb $H_2$ rapidly, with low activation energies of adsorption. A material comprising platinum is used with the present invention. Referring to the Periodic Table of the Elements, other electrocatalysts include, but are not necessarily limited to: Group IVA metals (Ti, Zr, Hf); Group VA metals (V, Nb, Ta), Group VIA metals (Cr, Mo, W); and, Group VIIA metals (Mn, Tc, Re). These metals appear to adsorb $H_2$ with high enthalpy of adsorption. Other electrocatalysts are metals which adsorb $H_2$ with lower heats, including but not necessarily limited to Groups VIIIA, B, and C (Fe, Ru, Os; Co, Rh, Ir, Ni, Pd, Pt),. The group IB metals (Cu, Ag, Au) have low heats of adsorption, but are not preferred as $H_2$ adsorption catalysts because they have slow activated chemisorption.

The Group VIII metals, preferred electrocatalysts for use in fuel cell electrodes, are believed to have heats of adsorption in a range which enables the reactant to chemisorb strongly enough to allow for surface reaction (electrochemical oxidation/reduction by breakdown and discharge of adsorbed species) but not strongly enough to form surface-bonded species. Due to the greater activation energy of chemisorption for oxygen, electrocatalytic reactions which involve surface oxygen require higher temperatures in order to produce satisfactory reaction rates than do reactions which involve surface hydrogen. For example, the most widely used oxygen electrodes for low temperatures are silver and platinum. Summarizing, useful catalysts for electrochemical applications include, but are not necessarily limited to Pt, Pd, Ru, Rh, Ir, Ag, Au, Os, Re, Cu, Ni, Fe, Cr, Mo, Co, W, Mn, Al, Zn, Sn.

In order to apply an electrocatalytic coating to the support; the electrocatalyst is heated to vaporization. The catalyst is heated using an electron beam.

The support is placed in a vacuum chamber provided with a crucible, preferably made of graphite, with a mechanism for directing a high power electron beam onto a solid chunk of the catalyst to produce a catalyst vapor. Platinum is the catalyst, and the catalyst is heated with the electron beam to between about 2300°C-2600°C (4172°F - 4712°F) to form a vapor.

During the deposition process, the pressure in the vacuum chamber should be pumped down to a pressure sufficient to cause the vapor to condense onto the support. The pressure is about 13.3 mPa (about $10^{-4}$ torr) or less. As used herein, the term "in a vacuum" is defined to mean a pressure of about 13.3 mPa ($10^{-4}$ torr) or less. The vaporized catalyst preferably should be allowed to deposit or condense onto the support in a vacuum. The temperature in the vacuum may vary; however, the temperature should be low enough not to damage the support, and low enough to permit the catalyst vapor to condense onto the support. The temperature 200°C or less. The deposition rate ranges from about 0.5-10Å/sec (0.05 - 1 nm/sec).

The deposition should continue until a catalytically effective amount of the catalyst is deposited onto the support.

As used herein, the term "catalytically effective" is defined to mean effective to catalyze the necessary reactions. The term "catalytically effective amount" is defined to mean as small an amount of the catalyst as possible to result in enough active catalyst to catalyze the necessary reactions. Typically, the amount of catalyst deposited to result in a catalytically effective amount should be from about 0.01 to about 0.3 mg/cm$^2$, preferably less than about 0.2 mg/cm$^2$. The thickness of the coating may be monitored by standard methods, e.g., using the frequency change of a quartz crystal oscillator. The weight of the film may be determined by weighing a known area of the support before and after depositing the film.

The support preferably is used as an electrode in a fuel cell. Preferred fuel cell electrodes are as thin as possible, typically having a thickness between about 0.010-0.175 inches (0.025 - 0.445 cm). Where the support is a PEM, the PEM preferably should be treated with a carbon catalyst support, such as carbon ink, using standard techniques well known in the art. Carbon supports preferably should be wet-proofed.

Individual membranes or electrodes may be prepared, or the process may be scaled up for production purposes. Where the support is thermally sensitive, cooling may be required. In the laboratory, cooling may be accomplished by mounting the support on the surface of an aluminum cylinder which is rotated through the ion and coating flux. With this setup, water cooling is no longer necessary because of the sufficiently large thermal mass of the cylinder combined with the fact that the support is no longer continuously exposed to the ion beam and coating flux. This fixture appears to hold promise from a scale-up perspective as large areas of support material can be rolled up on a drum and coated in a reel-to-reel process. Preferably, a scaled up arrangement will be a reel-to-reel arrangement in vaccuo. The coating technique described herein is adaptable for use with conventional "web coating" technologies.

Upon incorporation into a membrane electrode assembly and into a fuel cell supplied with hydrogen gas under suitable flow conditions, the electrocatalytic coating of the invention exhibits an open circuit voltage of at least about 0.8V, preferably about 1V. The term "open circuit voltage" or "open cell voltage" is defined as the spontaneous potential or voltage present in a fuel cell when no current is allowed to flow. This potential is known as the cell equilibrium potential and its theoretical value can be derived from thermodynamics using the Nernst relationship:

$$E = E^o + \frac{RT}{nF} \ln\left[\frac{\prod(\text{reactant activity})}{\prod(\text{product activity})}\right] \qquad [1]$$

where n is the number of electrons participating in the reaction, F is the Faraday's constant (96,439 coulombs/g-mole electron), R is the universal gas constant, T is the cell temperature and E° is the reversible standard cell potential for the reaction, which is directly related to the maximum electrical work $W_e$ obtainable in a fuel cell operating at constant temperature and pressure and is thermodynamically given by the change in Gibbs free energy ($\Delta G$) of the electrochemical reaction:

$$W_e = \Delta G^o = -nFE^o \qquad [2]$$

For the overall cell reaction, the open circuit potential increases with an increase in the activity of reactants and a decrease in the activity of products. Changes in cell temperature and pressure also influence the reversible cell potential. Practically, the open circuit voltage is the maximum voltage attainable during a fuel cell polarization or 1V curve, and corresponds to the cell potential at which the drawn net cell current is zero.

For example, after appropriate equilibration time, a PEM fuel cell will observe an open circuit voltage of from about 0.8 V and about 1 V versus a reference standard hydrogen electrode when operating: (a) at a temperature of from about 50° C to about 130° C; (b) with hydrogen and air as reactants; (c) humidified at a temperature of from about 50° C to about 140° C; (d) with relative humidities of from about 0 to about 100 %; (e) with pressures of from about 0 to about 100 psig (0.1 to 0.8 MPascal); and, (f) with flows large enough to assure complete irrigation of the electrocatalyst phase throughout the electrode.

The vacuum deposition techniques of the present invention are capable of forming large-area (>300 cm$^2$), high performance fuel cell electrodes with low Pt loadings (<0.3 mg/cm$^2$, preferably about 0.1 mg/cm$^2$) which are capable at a cell potential of about 0.6V of producing a power output of well over 400 mA cm$^{-2}$, preferably over about 800 mA cm$^{-2}$, most preferably about 1000 mA cm$^{-2}$, under the following conditions: in a single cell fuel cell fixture; with appropriate gas distribution manifolds and appropriate gasketing; using ELAT as gas diffusion material; with appropriate cell compression (from about 5.65 to about 33.89 N m/bolt, or about 50 to about 300 lb in/bolt compression torque); at cell operating conditions which typically include water saturation of the anode and (H$_2$) reactant feed at humidification temperatures of from about 40 to about 90°C; cell temperatures of about 40 to about 80°C; volumetric flowrate reactant feeds of about 1.2 -2 and about 2-5 times the stoichiometric value, for $H_2$ and air, respectively; and cell pressure set from about 0 to about 413.7 kPa gauge (1 and about 60 psig) for the anode ($H_2$ electrode) and cathode (air electrode).

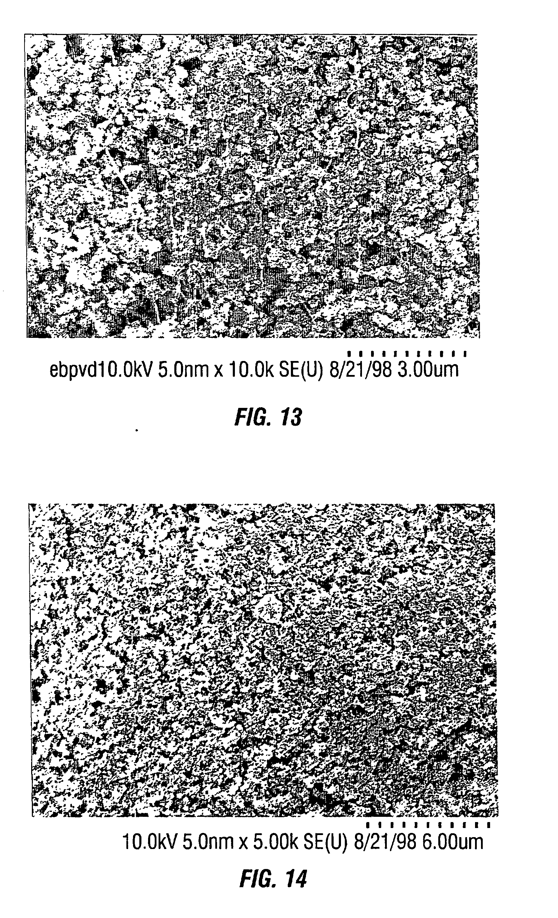

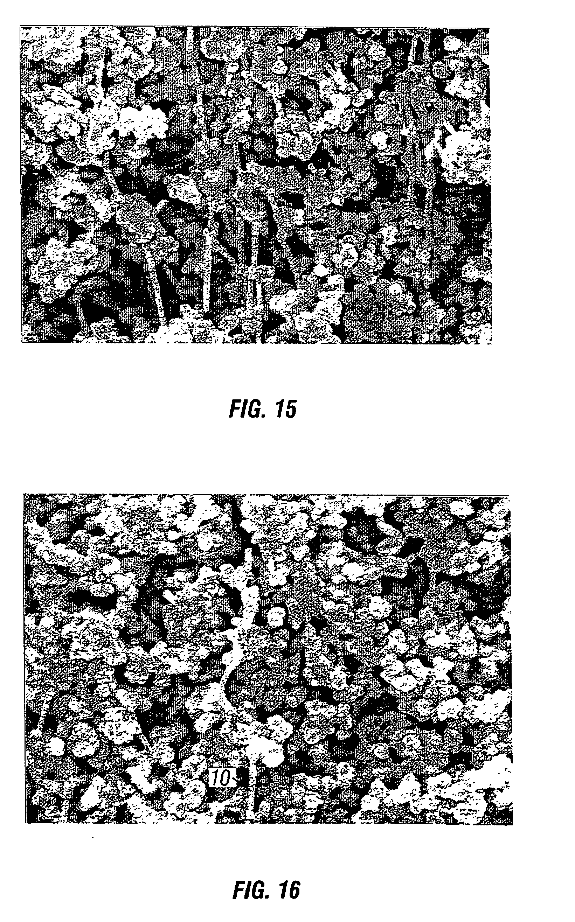

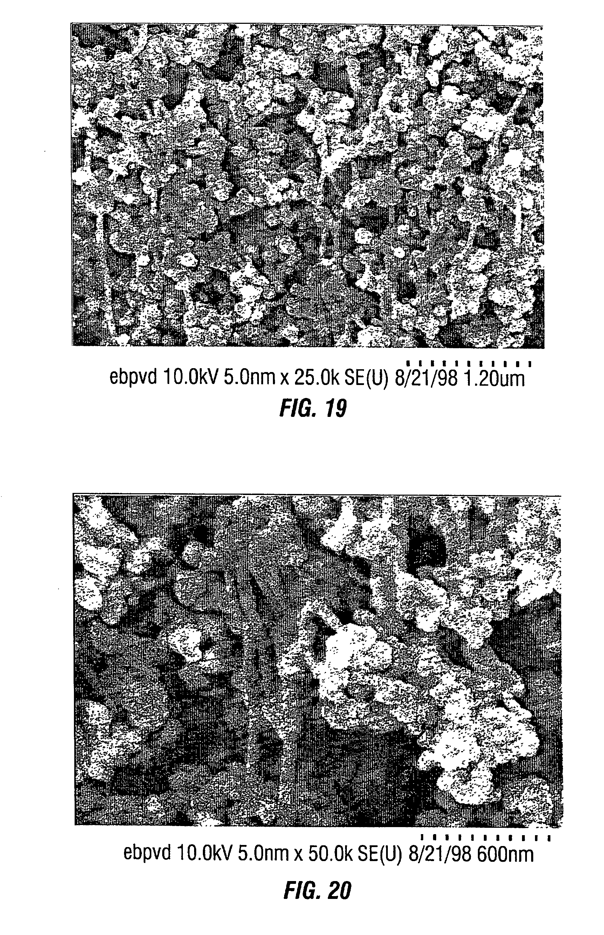

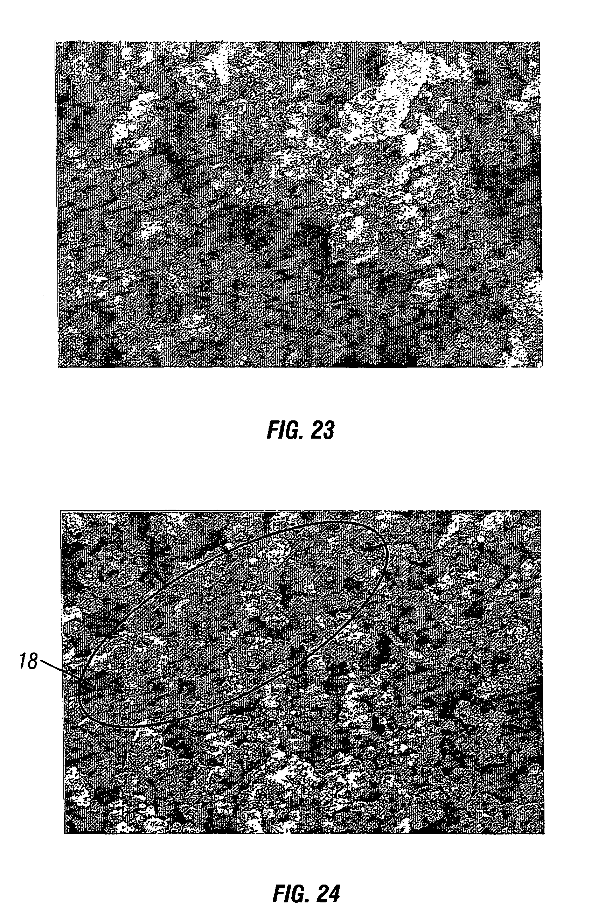

Tafel analysis on experimental cathodes (described in Example IV) demonstrates about a five-fold difference in oxygen reduction exchange current density between the vapor deposition techniques of the present invention and conventional sputtered electrodes ($i_{o,PVD}/i_{o,spurt} \sim 4.89$). The difference suggests that vapor deposited cathodes, such as the EB-PVD Pt deposited cathodes formed in Examples III and IV, have a substantially larger electrocatalytic active area or "three phase boundary" (TPB) than conventional sputtered Pt cathodes. This electrochemical conclusion was confirmed by field-emission scanning electron microscopy pictures (micrographs or FE-SEMs). FE-SEMs showed the presence of a microstructure in the inventive vapor deposited electrodes with readily recognizable Pt particles and the presence of "rod-shaped" structures 10, which become visible beginning at about x10k magnification, as shown in Figs. 14-15 and 17-22. These rod-shaped particles were not observed in the sputtered sample, as shown in Figs. 23-28.

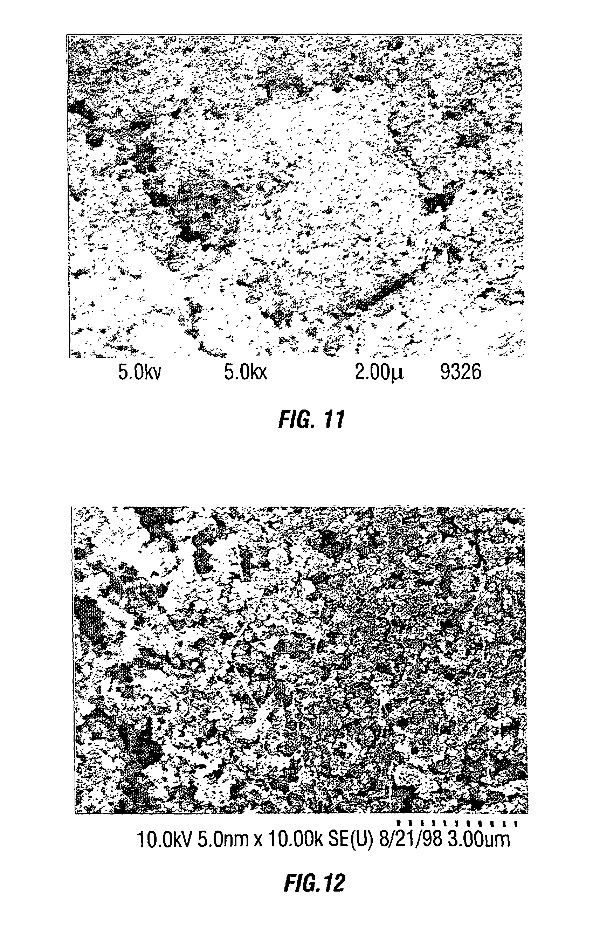

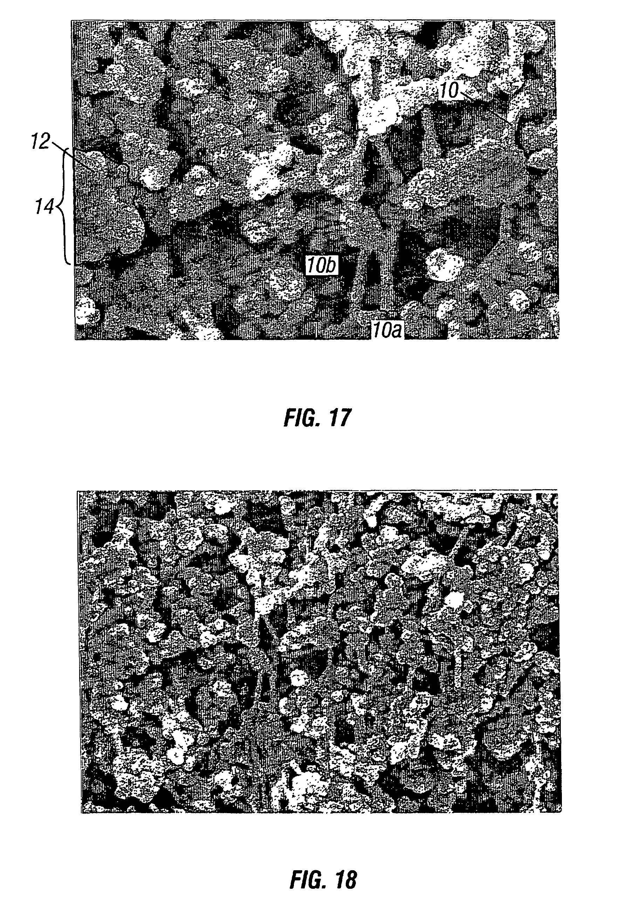

For purposes of the present application, the term "rod-shaped" is defined to mean substantially cylindrical shaped structures having a diameter 10a, as shown in Fig. 17, and a length 10b, as shown in Fig. 17. The rod-shaped structures shown in Figs. 12-13 and 15-20 have (a) a diameter 10a (Fig. 17) of from about 40-about 60 nm, typically about 60 nm, and (b) a length which is difficult to verify, but appears to vary.

Electrodes made according to the present invention may be used in fuel cells having many different constructions known to those skilled in the art. The invention will be better understood with reference to the following examples, which are for illustrative purposes only and should not be construed as limiting the invention, which is defined by the claims.

## EXAMPLE I

Using a vacuum chamber 2 m long and 1.5 m in diameter, candidate coatings were first deposited on glass slides and small coupons of representative membrane and electrode material, and subjected to compositional and microstructural analysis. Next, a series of larger-area electrode materials were coated and evaluated using a small home-built test cell, described below.

After a final down-selection, a limited number of full scale 150 cm² electrodes were fabricated and tested. Special sample fixtures, described in more detail in Example II, were developed to allow for the coating of carbon cloth electrodes over areas as large as 300 cm² Samples up to 250 cm² were coated using a planetary gear arrangement. The samples were asynchronously rotated through an electron beam-physical vapor deposition (EB-PVD) coating flux to ensure uniform deposition of the Pt over the entire electrode surface.

Carbon cloth and carbon paper materials, both plain and wet-proofed (i.e. coated with TEFLON®), were coated with 0.01, 0.05, and 0.10 mg/cm² of Pt. In addition, wet-proofed samples treated with a layer of carbon-only ELAT were procured from E-TEK for Pt coating in a similar manner.

A comparison of the thicknesses, morphologies, and Pt distributions of selected fuel cell electrode materials was performed using scanning electron microscopy (SEM) and transmission electron microscopy. The objective of such measurements was to determine the effect of electrode structure on the resulting efficiency of the fuel cell.

Performance analysis of catalyst coated electrode materials was undertaken using a small "home-built" test cell. The simple test cell consisted of two 6.9 cm stainless steel flanges used as collector plates with single air/hydrogen inlets and pairs of 100-mesh stainless steel screens mounted on each side of the electrode to provide a degree of gas diffusion. The cell active area was approximately 64 cm² and the same electrode material was used for both the anode and the cathode. The system was pressurized with humidified hydrogen and compressed air at 96.53 kPa (14 psig) and a flow rate of ~0.5 liters per minute. Current-voltage tests were conducted at ambient temperature at each outlet.

In all tests, the EB-PVD Pt-coated ELAT material repeatedly demonstrated superior behavior compared to a higher loaded control material, namely E-TEK platinum over VULCAN XC-72 ELAT solid polymer electrolyte electrode (4 mg/cm²). Measurable improvements in efficiency were observed for the carbon cloth with increasing Pt loading. It was also possible to further reduce the Pt loading of the EB-PVD coated carbon-only material on the anode side to as low as 0.01 mg/cm² with minimal reduction in performance.

## EXAMPLE II

Fabrication and testing of three full scale 150 cm² electrodes was performed based on the results of the screening tests with the small test fixture.

The electrodes prepared for testing are summarized in Table 2.

TABLE 2

| Sample I.D. | Membrane/Electrode Material | Deposition Method | Pt Loading (mg/cm$^2$) (Anode/Cathode) |
|---|---|---|---|
| 1 | 20 μm GORE SELECT®/C-only ELAT | EB-PVD Pt | 0.10/0.01 |
| 2 | 50 μm GORE SELECT®/C-only ELAT | EB-PVD Pt | 0.05/0.05 |
| 3 | 20 μm GORE SELECT®/C paper | Sputtered Pt | 0.10/0.10 |

In order to effectively evaluate the full-scale electrodes, a Scribner Associates Model 890 load system was leased for use with a test fixture. Basically, the test fixture consisted of the chosen membrane sandwiched by the chosen electrodes surrounded by graphite plates having flow channels to allow the passage of hydrogen and oxygen gas into contact with the electrodes. A metal plate sandwiched the assembly on each side. The metal plates had suitable holes drilled for introducing the hydrogen and oxygen gas, and electrical leads collected current and connected each plate to the load unit. The 1 kW, 125 amp Scribner load unit recorded all performance data from the cell while controlling the temperatures of the cell and feed gases, ensuring consistent, repeatable results. The comparison test fixture was rated at more than 100 watts depending on the configuration and operational mode. The modular design of the cell allowed for many different possible configurations and use of different material thicknesses.

Particular attention was paid to the gas handling system in assembling the test cell. All of the tubing and connectors were made of a 316 stainless steel and TEFLON (where electrical isolation was needed) in an effort to limit transport of metal cations into the cell. The gases were passed through a pair ofPerma Pure Inc. NAFION-based humidifiers and then carried to the cell via stainless tubing wrapped in heater tape to maintain proper temperature. Next, each gas was directed into 3-branch manifolds for the gas inlets and outlet. Exhaust gases were passed through a pair of flowmeters to measure the amount of excess fuel and air flow. Flowmeters were not installed on the upstream side as they contain a significant amount of aluminum parts which may contaminate the gases and hinder cell performance. A stainless steel reservoir with a built in heater was used to heat the cell and was controled by the Scribner load unit. A plastic submersible chemical pump circulated deionized water in a closed circuit composed of TEFLON tubing through the cell and humidifiers and back to the container. No active cooling of the cell was needed.

Performance tests typically were conducted at a temperature of 60°C, 30 psi (0.2 MPascal) humidified gasses, 3.5 time Stoichiometric Ratio (SR) or less on the air side, and 2 SR or less on the reactant side. The first objective was to match the performance curves for the electrode of the present invention with the control, comprising an electrode from a Gore PRIMEA® membrane electrode assembly, available commercially from W.L. Gore & Associates, Inc., under similar test conditions. After assembly, the cell was conditioned for several hours at low current. Once the performance stabilized, current voltage data was acquired starting at high currents and slowly ramping down.

Once the performance curve of the test membrane/electrode assembly had been matched with the performance curves of the controls, testing was performed. The cell was first conditioned for eight hours at a low current setting with humidified gasses at 30 psi (0.2 MPascal). The highest current density achieved using the 100nm/10nm EB-PVD Pt-coated ELAT with the 20 μm membrane was 732 mA/cm$^2$ at .358 V. In general, the overall power output of EB-PVD deposited electrode was 10-50% less than the output of the control. However, it is important to point out that this performance was achieved with less than 20% of the total Pt loading of the baseline material.

The foregoing tests demonstrate successful use of EB-PVD in the fabrication of 150 cm$^2$ membrane electrode assemblies with total Pt loadings as low as 0.11 mg/cm$^2$.

**EXAMPLE III**

Experiments were performed to characterize the electrochemical (fuel cell performance) and morphological properties of experimental electrodes prepared by Pt EV-PVD and magnetron sputtering of ELAT® gas diffusion media. MEAs prepared with PVD electrodes (cathodes or anodes) yielded superior polarization performance compared to the sputtered half cells.

*Electrode reparation*: Vacuum vaporization-based catalyzed electrodes were prepared using (a) electron-beam physical vapor deposition (EB-PVD) according to the present invention, and (b) conventional magnetron sputtering ofPt. In each case, the Pt was deposited onto double-sided ELAT commercial carbon-cloth gas diffusion media. The catalyzation took place onto the "active side" of the diffusor, i.e., on the side normally in contact with electrocatalyst layers.

For EV-PVD, a catalyst deposition rate of 1 Å/sec (0.1 nm/Sec) was chosen. The chamber base pressure was about 13.3 mPa (10$^{-5}$ torr). The Pt source was 99.95% purity.

For magnetron sputtering, a 15.24 cm (6 in) diameter magnetron sputtering unit was used to sputter Pt onto the substrate at a rate of about 2 to about 3 Å/sec (about 0.2 to about 0.3 nm/sec). The chamber base pressure was about 1.33 mPa ($10^{-4}$ torr). The Pt target was a foil with a purity 99.99%.

Electrodes at a loading level of 0.1 mg Pt $cm^{-2}$ were prepared using both techniques and compared. Energy dispersive spectroscopy (EDS) x-ray analysis detected only Pt as the vaporized phase using either technique. The catalyst layers formed using either technique had an average thickness of about 500Å (50nm).

The Pt-catalyst electrodes were incorporated into experimental MEA's using methods known in the art. In order to solely characterize the performance of the vacuum coated electrodes, *e.g.*, as cathodes, MEA's were prepared using a Gore PRIMEA® membrane electrode assembly as an anode, and vice versa when the vacuum coated electrode was characterized as the anode half cell. The Gore PRIMEA® membrane electrode assembly presented a loading of 0.1 mg Pt $cm^{-2}$ and the experimental MEA's used a 30 $\mu$m GORE SELECT® (950EW) perfluorinated membrane to form a membrane electrode assembly in all cases.

**EXAMPLE IV**

*Fuel Cell and Tafel Performance Tests:* To electrochemically characterize the performance of the experimental electrodes as cathodes and anodes, $H_2$/air fuel cell testing analysis was performed. The MEAs containing electrode active areas of 25 $cm^2$ and 30 $\mu$ GORE SELECT® membranes were mounted in standard fuel cell reactor fixtures using ELAT gas diffusion media for the reference half cell and were clamped to standard compression levels. The fuel cell test was conducted using a fuel cell station commercially available from Globetech, Inc., Bryant, TX. For the pressurized experiments, a 103.43/103.43 kPa and 206.85/206.85 kPa (15/15 psig and 30/30 psig) gauge anode and cathode, respectively; the cell temperature was set at about 80 ° C with anode and cathode feeds humidified at about 60-70°C and 85°C; and, flowrates set at 2/3.5 times the stoichiometric value for $H_2$ and air, respectively. In some tests, a constant flow of 500-1000 standard $cm^3$/min was used for the $H_2$ and air, respectively. For the atmospheric pressure runs, the cell temperature and reactant humidification was set at about 60°C. The performance was evaluated at different times on stream (TOS).

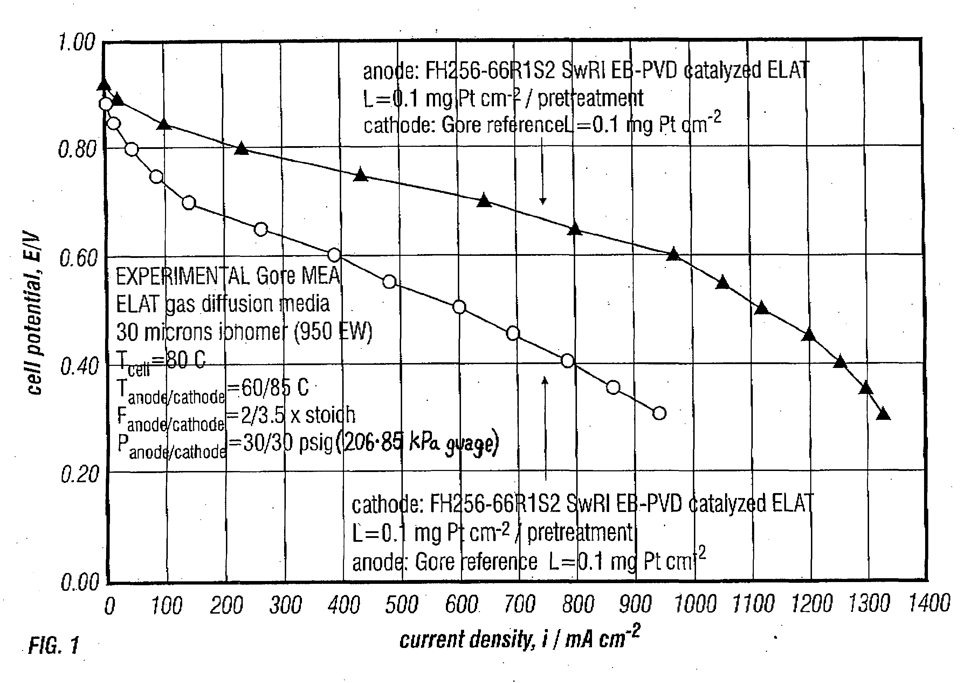

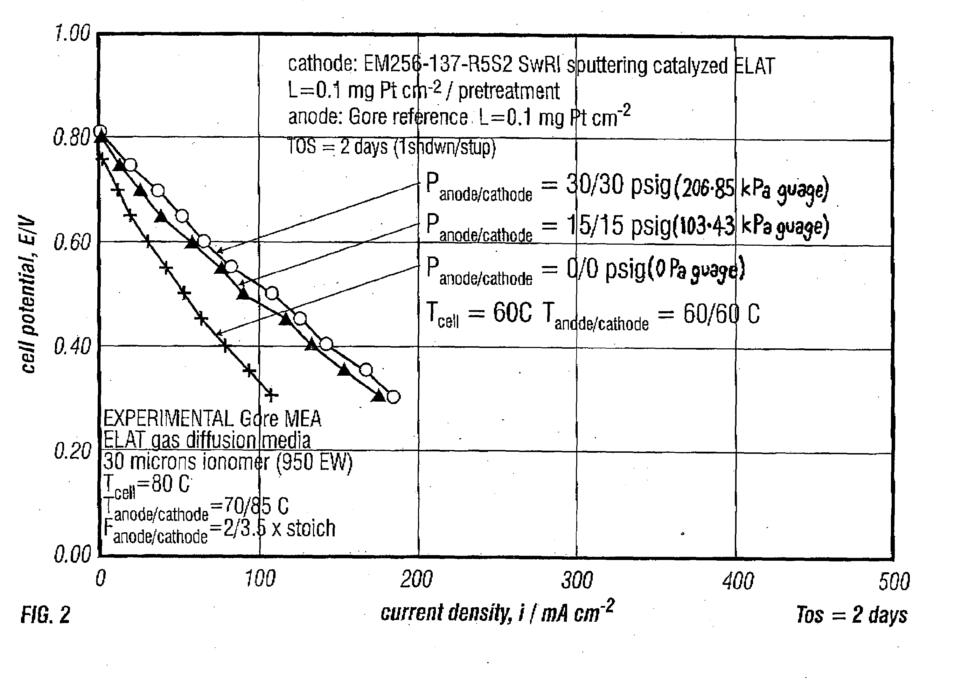

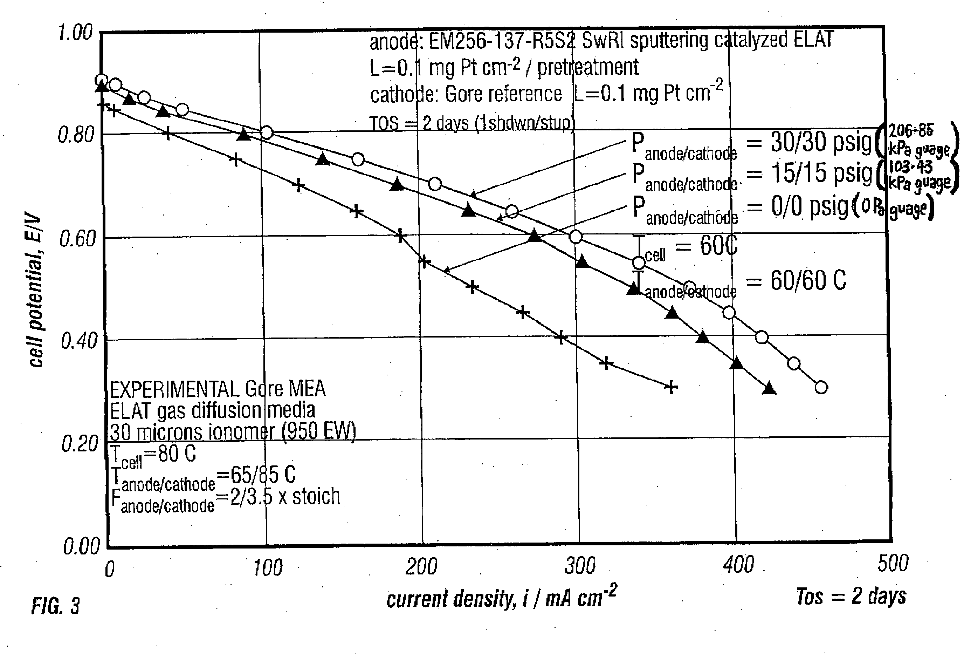

*Fuel Cell Performance Analysis:* Fig. 1 shows the polarization performance at 206.85 (30 psig) cell pressure of a Pt EB-PVD catalyzed ELAT gas diffusion media experimental electrode used as a cathode and anode. The MEA used was a Gore PRIMEA® membrane electrode assembly (anode or cathode). Figs. 2 and 3 are the equivalent graphs (at different cell pressures) for the Pt-sputtered experimental electrode used as cathode and anode. Polarization performance from these graphs suggests that the Pt evaporated electrode displayed superior performance compared to the sputtered electrode for both cathode and anode operation.

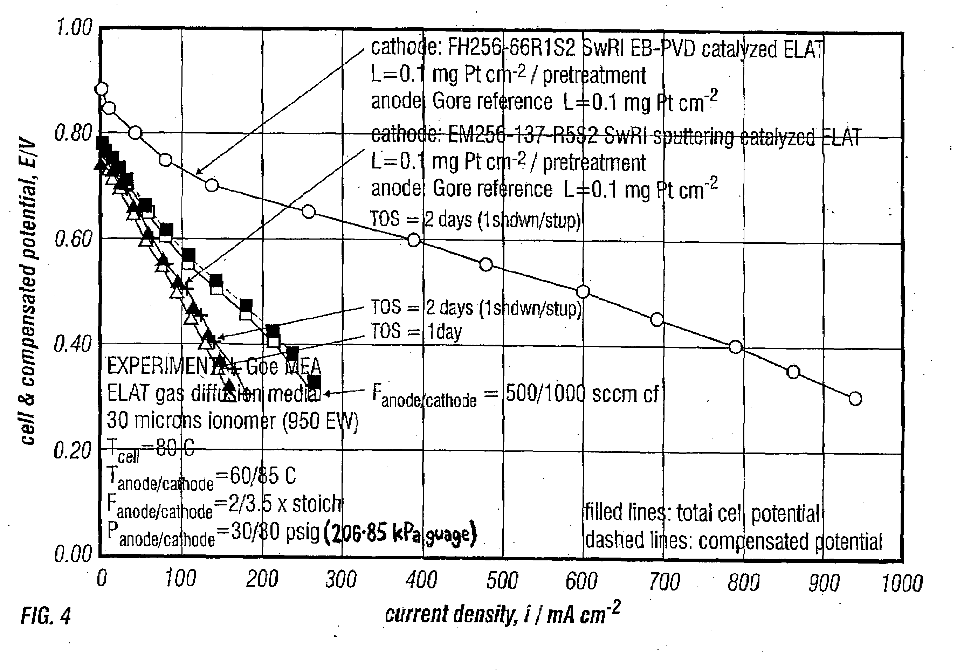

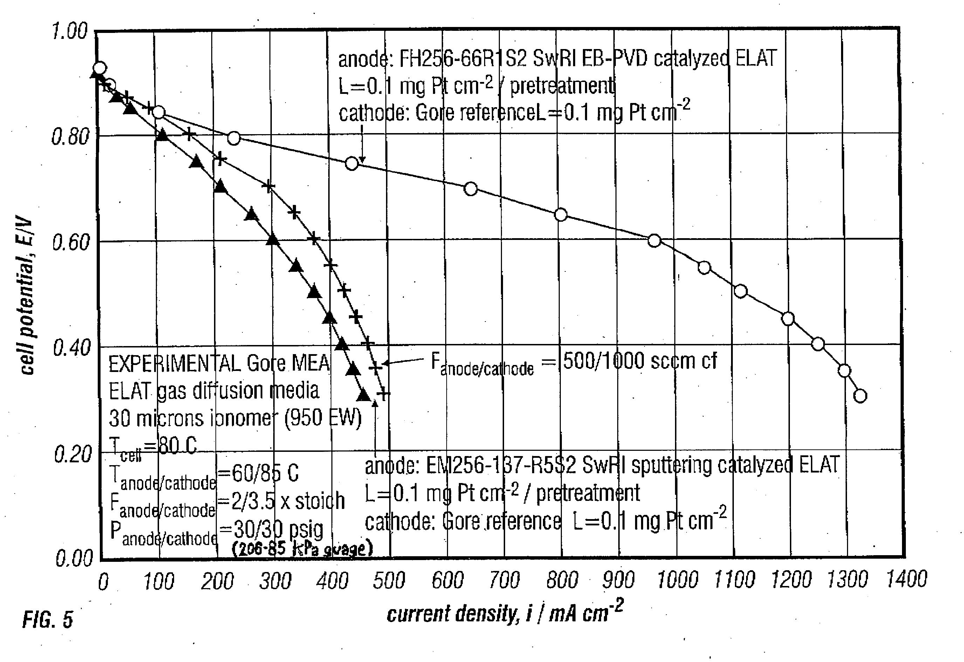

Figures 4 and 5 show a side-by-side comparison of performance between both vacuum catalyzation technologies. When used as a cathode, the inventive PVD catalyzed electrode showed improved performance throughout the entire polarization curve, i.e., OCV, activation region, ohmic region and mass transport region, compared with the sputtering catalyzed electrode (Fig. 4 ). For example, at 0.6V, the MEA containing the PVD half cell operating as cathode yielded about 400 mA $cm^{-2}$ with an OCV of 0.889 V against 60-100 mA $cm^{-2}$ and OCV of 0.779-0.810 V for the sputtered system (i.e., 4 times lower performance). The compensated (IR-free) performance for the sputtered system followed the curve for the total cell potential indicating that the controlling electrode was the cathode half cell.

Fig. 5 shows the same analysis, but with the vacuum vaporized electrode used as anode. Here, although the OCV and the catalyst regions of the polarization curves were comparable for both systems (as expected due to the reference cathode operating as cathode in both cases), the IR region and the mass transport region for the MEA containing the sputtered electrode demonstrated substantially lower performance, i.e., larger slope, (larger membrane resistance and anode linear polarization losses) and more pronounced mass transport effects. For example, at 0.6 V cell potential, the MEA containing the sputtered anode yielded between 300 and 400 mA $cm^{-2}$ while the PVD anode-containing MEA yielded almost 1000 mA $cm^{-2}$. The difference in performance observed in this case (experimental electrode used as anode) was mostly due to anode polarization differences: at 0.6 V the sputtered anode suffered about 240 mV polarization loss against 92 mV polarization loss for the EB-PVD cathode.

*Tafel Analysis*: In order to rationalize the difference in performance of electrodes made using EB-PVD versus sputtering, the electrocatalytic activity/activation polarization performance of the electrode was probed using a Tafel analysis. Briefly, a fuel cell polarization curve can be described using the semi-empirical equation:

$$E = E_o - b\log i - iR - me^{ni}$$

where the first negative term ($-b\log i$ ) indicates the cathode activation loss (electrocatalyst/electrodics, i.e., resistance to charge transfer), the second negative term ($-iR$) addresses the ohmic losses due to membrane resistance, contact potential and anode linear polarization losses, and the third negative term ($-me^{ni}$) addresses mass transport polarization losses. During a Tafel analysis, the ohmic and mass transport losses are normally eliminated and electrocatalytic parameters are measured by curve fitting the data to the following expression:

$$E_c = E + iR \simeq E_o - b\log i$$

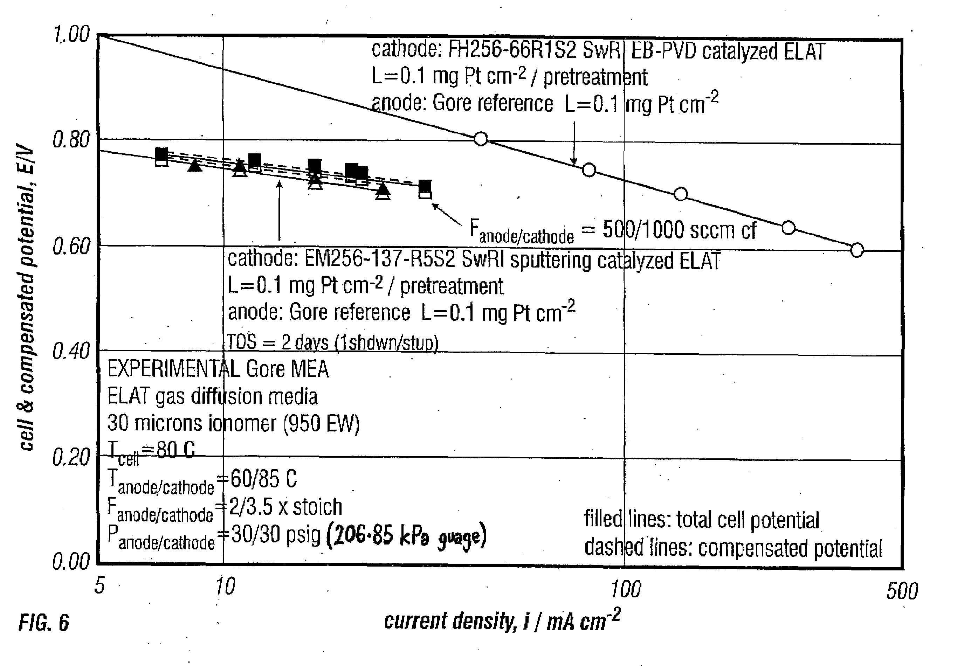

where the compensated (*iR*-free) cell potential is used to eliminate any ohmic loss that could be present in the catalyst region of the polarization curve. The Tafel slope, *b* and the parameter $E_o$ (which is related to the exchange current density $i_o$, and, thus related to the polarizability of the interface due to its dependence with the intrinsic electrocatalytic activity and the length of three phase boundary, TPB, i.e., number of electrocatalytic active sites or electrochemically active surface area) were then evaluated for the evaporated and sputtered vacuum coated electrodes used as a cathode (controlling half cell). The experimental Tafel curve is shown in Fig. 6.

Tafel analysis suggested that, although the Tafel slope for the evaporated electrode was larger than the sputtered electrode, the PVD cathode provided a substantially larger electrocatalytic active area (larger TPB) than the sputtered cathode, as found comparing the $E_n$ values for both electrodes 1.145V (PVD) versus 0.853 V (sputtering). The superior polarization performance of the PVD electrode compared with the sputtered electrode can then be explained on the basis that the exchange current density $i_o$ for oxygen reduction in the evaporated electrodes was about 5 times higher than that in the sputtered electrode due to the larger electrochemically active area.

Although the foregoing argument is directly valid for the catalyst region of the polarization curve, the difference in performance observed at the ohmic and mass transport regions of the curve is only indirectly related to the reduced electrocatalytic active area. Factors which would directly relate to the difference in performance at the ohmic and mass transport regions of the curve would be, *e.g.*, reduced hydration of membrane (due to lower current densities) or flooding. These factors, nevertheless, are directly related to current density, which is directly related to the extent of electro catalytic area.

*FE-SEM Analysis*: In order to characterize the microstructure of the vacuum catalyzed electrodes, field-emission SEM was performed. FE-SEM micrographs for the uncatalyzed ELAT gas diffusion media were compared to FE-SEM micrographs for the Pt EB-PVD catalyzed ELAT diffusor and Pt sputtered catalyzed diffusor. Magnifications from x5k up to x50k were used. Pictures with x25k and x50k magnification showed most of the differences in structure.

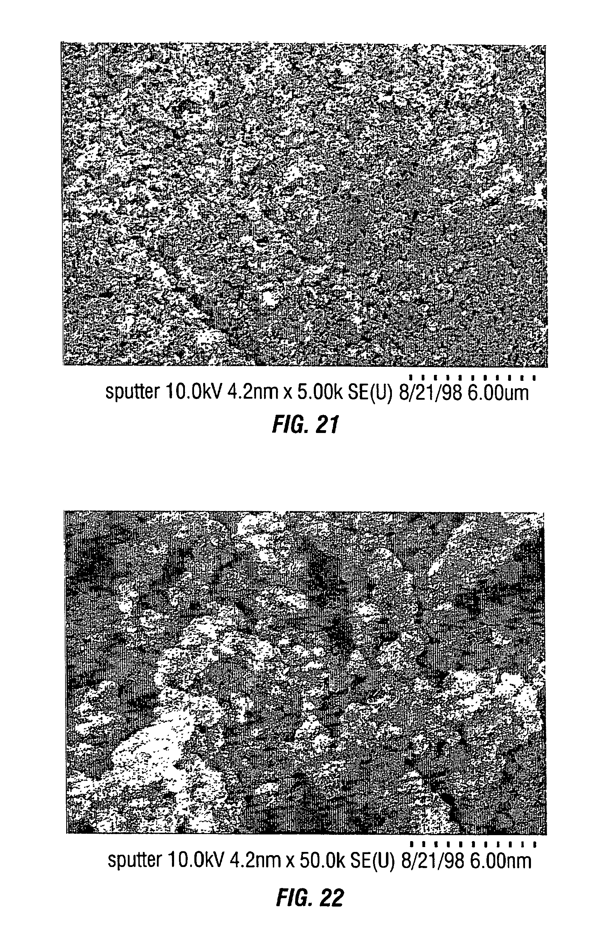

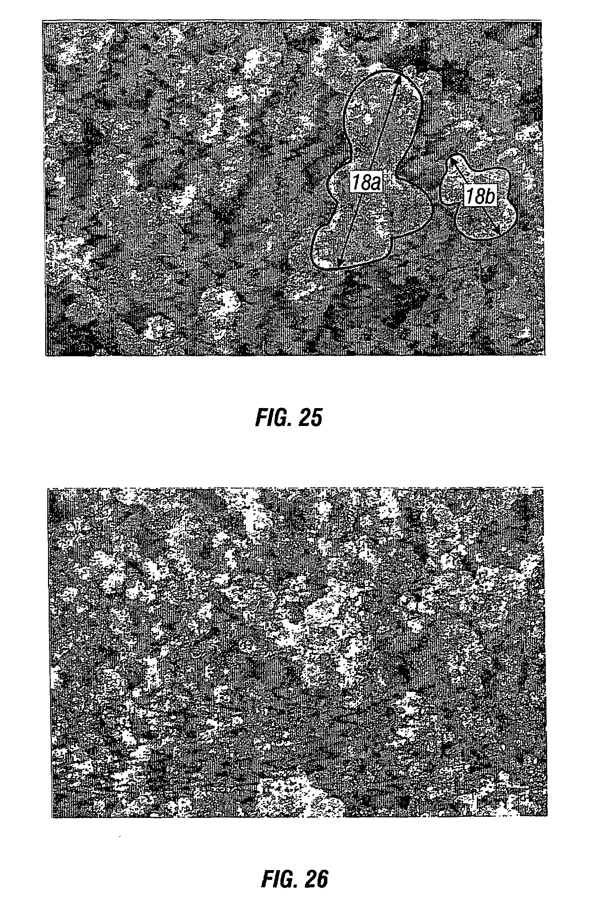

Significant differences on the morphology of the Pt catalyst coating were observed between the EB-PVD and magnetron sputtering coating technologies. On the sputtered sample, the Pt particles were in the form of aggregates (Figs. 21-26), and in some cases the particles appeared to coalesce and form larger "fused" particles with a longitudinal dimension (Fig. 23) of from about 400 to about 1000 nm. In these "fused" particles (Fig. 23), the outer surface of individual particles was no longer visible (18, 18a, and 18b in Figs. 24 and 25).

On the EB-PVD catalyzed sample, the Pt particles were in the form of aggregates and in some cases the particles (12, Fig. 17) appeared to coalesce and form patches (14, Fig. 17). But the outer surface of individual Pt particles (12, Fig. 17) was readily recognizable in the coalesced patches as compared to that of the coalesced particles in the Pt sputtered sample (18, 18a, 18b, Figs. 24 and 25). In addition, a good amount of rod-like Pt particles 10 (Figs. 17 and 18) were observed on the EB-PVD catalyzed sample. These rod-like particles were not observed in the sputtered sample.

It will be appreciated that the present invention may be modified within the scope of the appended claims. The embodiments described herein are meant to be illustrative only and should not be taken as limiting the invention, which is defined in the following claims.

**Claims**

**1.** A method for making a fuel cell electrode, the method comprising:

heating a soli material comprising platinum in a vacuum to a temperature of from 2300 to 2600°C by directing an electron beam onto the solid material to convert the solid material into a vapor; and

depositing the vapor onto a carbon catalyst support comprising a material selected from the group consisting of graphite, a carbon filament bundle, reticulated carbon, carbon cloth, and carbon mesh, the depositing occurring at a pressure of 13.3 mPa or less at a temperature of 200 °C or less and at a deposition rate of from 0.05 to 1 nm/second, whereby the depositing step produces a catalytically effective coating on the carbon catalyst support;

incorporating the coated carbon catalyst support into a fuel cell electrode, whereby the coated support is effective to catalyze the conversion of hydrogen and oxygen to water and electricity, and whereby, when a concentration of the catalytically effective coating comprises less than 0.3 mg/cm$^2$, said electricity is 1A/cm$^2$ or more at 0.6 V.

2. The method of claim 1 wherein said carbon catalyst support is a coating on carbon cloth and said coating is selected from the group consisting of carbon, a wet proofing material, and a combination thereof.

3. The method of claim 2 wherein said wet proofing material is poly tetrafluoroethylene.

4. A method according to any preceding claim, wherein the concentration is less than 0.3 mg/cm$^2$, preferably less than 0.2 mg/cm$^2$ and most preferably from 0.01 to 0.2 mg/cm$^2$.

5. A method according to any preceding claim, wherein the support is arranged in ionic communication with a solid polymer electrolyte membrane.

6. A method according to claim 5, wherein said solid polymer electrolyte membrane has a first side and a second side opposite said first side, and said method further comprises disposing said support on each of said first side and said second side to produce a membrane electrode assembly.

7. An electrode obtainable by a method according to any preceding claim, comprising an electrocatalytic active area at least in part comprising rod-shaped structures, which rod-shaped structures are preferably visible at a magnification of at least x10k.

8. An electrode according to claim 7 comprising an electrocatalytic active area of 300 cm$^2$ or greater.

9. An electrode according to claim 7 or 8 wherein the coating comprises particles of said electrocatalyst including an outer surface, wherein said electrocatalytic active area comprises a majority of said outer surface of said particles.

10. An electrode according to any of claims 7 to 9 wherein substantially all of the surface area of the support communicates ionically with an ionomeric membrane.

11. A membrane electrode assembly comprising the electrode according to any of claims 7 to 10, whereby, at a cell potential of 0.6 V, when containing said electrode as a half cell operating as a cathode is capable of yielding 400 mA cm$^{-2}$ or greater and preferably 800mA cm$^{-2}$ or greater and most preferably 1000 mA cm$^{-2}$ or greater.

**Patentansprüche**

1. Verfahren zum Herstellen einer Brennstoffzellen-Elektrode, wobei das Verfahren umfasst;
Erhitzen eines festen Materials, das Platin umfasst, in einem Vakuum auf eine Temperatur von 2300 bis 2600°C durch Richten eines Elektronenstrahls auf das feste Material, um das feste Material in einen Dampf umzuwandeln; und
Abscheiden des Dampfes auf einem Kohlenstoff-Katalysatorträger, der ein Material umfasst, das aus der Gruppe ausgewählt wird, die aus einem Kohlefadenbündel, netzartigem Kohlenstoff (reticulated carbon), Kohlenstoffgewebe und Carbon-Mesh besteht, wobei das Abscheiden bei einem Druck von 13,3 mPa oder weniger, einer Temperatur von 200°C oder weniger und einer Abscheiderate von 0,05 bis 1 nm/s stattfindet und der Abscheideschritt eine katalytisch wirksame Beschichtung auf dem Kohlenstoff-Katalysatorträger erzeugt;
Integrieren des beschichteten Kohlenstoff-Katalysatorträgers in eine Brennstoffzellen-Elektrode, wobei der beschichtete Träger Katalyse der Umwandlung von Wasserstoff und Sauerstoff in Wasser und Elektrizität bewirkt und, wenn eine Konzentration der katalytisch wirksamen Beschichtung weniger als 0,3 mg/cm$^2$ beträgt, die Elektrizität 1A/cm$^2$ oder mehr bei 0,6 V beträgt.

2. Verfahren nach Anspruch 1, wobei der Kohlenstoff-Katalysatorträger eine Beschichtung auf Kohlenstoffgewebe ist und die Beschichtung aus der Gruppe ausgewählt wird, die aus Kohlenstoff, einem Feuchtigkeitsschutzmaterial und einer Kombination daraus besteht.

3. Verfahren nach Anspruch 2, wobei das Feuchtigkeitsschutzmaterial Polytetrafluorethylen ist.

4. Verfahren nach einem der vorangehenden Ansprüche, wobei die Konzentration weniger als 0,3 mg/cm$^2$, vorzugsweise weniger als 0,2 mg/cm$^2$ und am besten von 0,01 bis 0,2 mg/cm$^2$ beträgt.

5. Verfahren nach einem der vorangehenden Ansprüche, wobei der Träger in Ionenverbindung (ionic communication) mit einer SPE-Membran (solid polymer electrolyte membrane) steht.

6. Verfahren nach Anspruch 5, wobei die SPE-Membran eine erste Seite und eine der ersten Seite gegenüberliegende zweite Seite hat und das Verfahren des Weiteren Anordnen des Trägers sowohl an der ersten als auch der zweiten Seite umfasst, um eine Membran-Elektroden-Anordnung zu erzeugen.

7. Elektrode, die mit einem Verfahren nach einem der vorangehenden Ansprüche hergestellt werden kann und eine elektrokatalytisch aktive Fläche umfasst, die wenigstens teilweise stangenförmige Strukturen umfasst, wobei die stangenförmigen Strukturen vorzugsweise bei einer Vergrößerung von wenigstens x10k sichtbar sind.

8. Elektrode nach Anspruch 7, wobei eine elektrokatalytisch aktive Fläche 300 cm$^2$ oder mehr beträgt.

9. Elektrode nach Anspruch 7 oder 8, wobei die Beschichtung Teilchen des Elektrokatalysators umfasst, die eine Außenfläche enthalten und die elektrokatalytisch aktive Fläche einen Großteil der Außenfläche der Teilchen umfasst.

10. Elektrode nach einem der Ansprüche 7 bis 9, wobei im Wesentlichen die gesamte Oberfläche des Trägers in Ionenverbindung mit einer Ionomer-Membran steht.

11. Membran-Elektroden-Anordnung, die die Elektrode nach einem der Ansprüche 7 bis 10 umfasst, wobei sie bei einem Zellenpotenzial von 0,6 V, wenn die Elektrode als eine Halbzelle enthalten ist, die als eine Kathode arbeitet, 400 mA cm$^{-2}$ oder mehr und vorzugsweise 800 mA cm$^{-2}$ oder mehr und am besten 1000 mA cm$^{-2}$ oder mehr liefern kann.

**Revendications**

1. Procédé de fabrication d'une électrode pour pile à combustible, le procédé comprenant :

le chauffage d'un matériau solide comprenant du platine sous vide à une température allant de 2 300 °C à 2 600 °C en dirigeant un faisceau d'électrons sur le matériau solide pour convertir le matériau solide en vapeur ; et le dépôt de la vapeur sur un support de catalyseur à base de carbone comprenant un matériau choisi dans le groupe constitué par le graphite, un faisceau de filaments de carbone, un carbone réticulé, un tissu de carbone et un filet de carbone, le dépôt étant réalisé sous une pression inférieure ou égale à 13,3 mPa à une température inférieure ou égale à 200 °C et à une vitesse de dépôt allant de 0,05 nm/seconde à 1 nm/seconde, moyennant quoi l'étape de dépôt produit un revêtement efficace sur le plan catalytique sur le support de catalyseur à base de carbone ;
l'incorporation du support de catalyseur à base de carbone qui a été revêtu dans une électrode pour pile à combustible, moyennant quoi le support revêtu est efficace pour catalyser la conversion de l'hydrogène et de l'oxygène en eau et en électricité et,
moyennant quoi, quand une concentration du revêtement efficace sur le plan catalytique comprend moins de 0,3 mg/cm$^2$, ladite électricité est supérieure ou égale à 1 A/cm$^2$ à 0,6 V.

2. Procédé selon la revendication 1, dans lequel ledit support de catalyseur à base de carbone est un revêtement sur un tissu de carbone et ledit revêtement est choisi dans le groupe constitué par le carbone, un matériau à l'épreuve de l'humidité et une combinaison de ceux-ci.

3. Procédé selon la revendication 2, dans lequel ledit matériau à l'épreuve de l'humidité est un polytétrafluoroéthylène.

4. Procédé selon l'une quelconque des revendications précédentes, dans lequel la concentration est inférieure à 0,3 mg/cm$^2$, de préférence inférieure à 0,2 mg/cm$^2$ et de manière préférée entre toutes de 0,01 mg/cm$^2$ à 0,2 mg/cm$^2$.

5. Procédé selon l'une quelconque des revendications précédentes, dans lequel le support est arrangé en communication ionique avec une membrane électrolyte polymère solide.

6. Procédé selon la revendication 5, dans lequel ladite membrane électrolyte polymère solide présente une première face et une seconde face opposée à ladite première face, et ledit procédé comprend en outre le dépôt dudit support sur chacune de ladite première face et de ladite seconde face pour produire un assemblage membrane-électrode.

**7.** Electrode pouvant être obtenue grâce à un procédé selon l'une quelconque des revendications précédentes, comprenant une zone électrocatalytique active comprenant au moins partiellement des structures en forme de tiges, lesdites structures en forme de tiges étant de préférence visibles à un grossissement d'au moins x10k.

**8.** Electrode selon la revendication 7, comprenant une zone électrocatalytique active de 300 cm$^2$ ou plus.

**9.** Electrode selon la revendication 7 ou 8, dans laquelle le revêtement comprend des particules dudit électrocatalyseur comprenant une surface externe, dans lequel ladite zone électrocatalytique active comprend une majorité de ladite surface externe desdites particules.

**10.** Electrode selon l'une quelconque des revendications 7 à 9, dans lequel sensiblement toute la surface du support communique par voie ionique avec une membrane ionomère.

**11.** Assemblage membrane-électrode comprenant l'électrode selon l'une quelconque des revendications 7 à 10, moyennant quoi à un potentiel de pile de 0,6 V, quand il contient ladite électrode en tant que demi-cellule fonctionnant en tant que cathode, est capable de fournir 400 mA cm$^{-2}$ ou plus, et de préférence 800 mA cm$^{-2}$ ou plus, et de manière préférée entre toutes 1 000 mA cm$^{-2}$ ou plus.

FIG. 1

FIG. 2

FIG. 3

anode: EM256-137-R5S2 SwRl sputtering catalyzed ELAT
L=0.1 mg Pt cm⁻² / pretreatment
cathode: Gore reference L=0.1 mg Pt cm⁻²
TOS = 2 days (1shdwn/stup)

$P_{anode/cathode}$ = 30/30 psig (206-85 kPa guage)
$P_{anode/cathode}$ = 15/15 psig (103-43 kPa guage)
$P_{anode/cathode}$ = 0/0 psig (0 Pa guage)

$T_{cell}$ = 60C
$T_{anode/cathode}$ = 60/60 C

EXPERIMENTAL Gore MEA
ELAT gas diffusion media
30 microns ionomer (950 EW)
$T_{cell}$=80 C
$T_{anode/cathode}$=65/85 C
$F_{anode/cathode}$=2/3.5 x stoich

cell potential, E/V

current density, i / mA cm⁻²

Tos = 2 days

EP 1 021 590 B1

FIG. 4

EP 1 021 590 B1

FIG. 5

FIG. 6

cathode: FH256-66R1S2 SwR EB-PVD catalyzed ELAT
L=0.1 mg Pt cm$^{-2}$ / pretreatment
anode: Gore reference L=0.1 mg Pt cm$^{-2}$

$F_{anode/cathode}$ = 500/1000 sccm cf

cathode: EM256-137-R5S2 SwRI sputtering catalyzed ELAT
L=0.1 mg Pt cm$^{-2}$ / pretreatment
anode: Gore reference L=0.1 mg Pt cm$^{-2}$
TOS = 2 days (1shdwn/stup)

EXPERIMENTAL Gore MEA
ELAT gas diffusion media
30 microns ionomer (950 EW)
$T_{cell}$=80 C
$T_{anode/cathode}$=60/85 C
$F_{anode/cathode}$=2/3.5 x stoich
$P_{anode/cathode}$=30/30 psig (206.85 kPa guage)

filled lines: total cell potential
dashed lines: compensated potential

cell & compensated potential, E/V

current density, i / mA cm$^{-2}$

EP 1 021 590 B1

Magn ⊢————————⊢ 5 μm
5000x

*FIG. 7*

10.0kV 4.2nm x 10.0k SE(U) 8/21/98 3.00um

*FIG. 8*

10.0kV 4.2nm x 50.0k SE(U) 8/21/98 600nm

*FIG. 9*

ebpvd 10.0kV 5.0nm x 5.00k SE(U) 8/21/98 6.00um

*FIG. 10*

5.0kv     5.0kx     2.00µ    9326

**FIG. 11**

10.0kV 5.0nm x 10.00k SE(U) 8/21/98 3.00um

**FIG.12**

ebpvd10.0kV 5.0nm x 10.0k SE(U) 8/21/98 3.00um

*FIG. 13*

10.0kV 5.0nm x 5.00k SE(U) 8/21/98 6.00um

*FIG. 14*

**FIG. 15**

**FIG. 16**

**FIG. 17**

**FIG. 18**

ebpvd 10.0kV 5.0nm x 25.0k SE(U) 8/21/98 1.20um

*FIG. 19*

ebpvd 10.0kV 5.0nm x 50.0k SE(U) 8/21/98 600nm

*FIG. 20*

sputter 10.0kV 4.2nm x 5.00k SE(U) 8/21/98 6.00um

*FIG. 21*

sputter 10.0kV 4.2nm x 50.0k SE(U) 8/21/98 6.00nm

*FIG. 22*

**FIG. 23**

**FIG. 24**

**FIG. 25**

**FIG. 26**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5277996 A
- US 5624718 A